(19) Europäisches Patentamt
European Patent Office
Office européen des brevets

(11) EP 2 141 754 A2

(12) EUROPEAN PATENT APPLICATION

(43) Date of publication:
06.01.2010 Bulletin 2010/01

(51) Int Cl.:
*H01L 51/52* (2006.01)

(21) Application number: 09164529.1

(22) Date of filing: 03.07.2009

(84) Designated Contracting States:
AT BE BG CH CY CZ DE DK EE ES FI FR GB GR HR HU IE IS IT LI LT LU LV MC MK MT NL NO PL PT RO SE SI SK SM TR

(30) Priority: 04.07.2008 JP 2008176236

(71) Applicant: FUJIFILM Corporation
Minato-ku
Tokyo 106-0031 (JP)

(72) Inventor: Agata, Yuya
Kanagawa 258-8577 (JP)

(74) Representative: HOFFMANN EITLE
Patent- und Rechtsanwälte
Arabellastrasse 4
81925 München (DE)

# (54) Barrier laminate, gas barrier film, device and optical member

(57) Disclosed is a barrier laminate comprising an organic layer, a protection layer and an inorganic layer in that order, wherein the organic layer comprises a main component other than a polyparaxylylene, and the protection layer comprises a polyparaxylylene as a main component.

EP 2 141 754 A2

## Description

Field of the invention

The present invention relates to a barrier laminate having low vapor water permeability which is excellent in adhesiveness between layers. It also relates to a gas barrier film comprising the barrier laminate on a substrate film. Particularly, it relates to a device using the barrier laminate or the gas barrier film, particularly an electronic device, further particularly an organic device. It also relates to an optical member using the barrier laminate or the gas barrier film.

Description of the related art

Heretofore, a gas barrier film in which an inorganic layer comprising a metal oxide such as aluminum oxide, magnesium oxide and silicon oxide was formed on a surface of a plastic film is widely used for a package of articles which requires to be shut out from various gases such as vapor and oxygen and for a package to prevent industrial goods, medical products and the like from changing in their qualities.

In the recent years, in the field of a liquid crystal display device or an organic EL device, plastic film substrates start to be replaced with glass substrates, which are heavy and easily broken. Since such plastic film substrates are applicable to a Roll to Roll system, its cost is advantageous. However, such plastic film substrates have a problem in that the plastic film substrate is poorer in moisture vapor barrier property than glass substrates. Therefore, when the plastic film is used for a liquid crystal display device, moisture vapor infiltrate into the liquid crystal cell, causing its display failure.

It is known to use a gas barrier film in which a barrier laminate is provided on a substrate film in order to solve the problem. For example, JP-B-53-12953 discloses at pages 1 to 3 a gas barrier film in which silicon oxide is deposited on a plastic film. JP-A-58-217344 discloses at pages 1 to 4 a gas barrier film in which aluminium oxide is deposited on a plastic film. Those films have a vapor water permeability of about 1 $g/m^2/day$.

However, in order to use the gas barrier film as a substrate of a device such as an organic EL device, further higher barrier property is required. As means to meet such requirement, JP-A-2003-335880 and JP-A-2003-335820 disclose the technique realizing less than 0.1 $g/m^2/day$ of the vapor water permeability, and further more, US Patent Registration No. 6,413,645 discloses the technique realizing 0.001 $g/m^2/day$ of the vapor water permeability by employing a gas barrier film having an organic layer and an inorganic layer, what is called as an organic/inorganic laminate gas barrier film.

Summary of the invention

The inventor has studied on the organic/inorganic laminate gas barrier film disclosed in the above and has found that, when an inorganic layer is formed on a surface of an organic layer, the organic layer is damaged, thereby adversely affecting its surface smoothness and the inorganic layer, and as a result, the barrier property is sufficiently not exerted. Particularly, he has found that the problem is serious in the case where the inorganic layer is formed by a sputtering method or a CVD method. On the other hand, the organic layer has a substantial need when the gas barrier film is applied for a flexible display such as an organic EL device since the organic layer smoothes the surface and works as a stress relaxation layer in bending.

The first object of the present invention is to provide an organic/inorganic laminate gas barrier film which has low vapor permeability and of which barrier property does not decrease even if it is bent repeatedly.

The second object of the present invention is to provide a device having high durability by using the gas barrier film.

Given the situation as above, the present investor has assiduously studied and has found that the above problems can be solved by providing a protection layer comprising a polyparaxylylene as a main component, which is purpose for protecting an organic layer as a base layer from the damage in the case where an inorganic layer is formed on the Organic layer. Specifically, the aforementioned problem can be solved by the following means.

[1] A barrier laminate comprising an organic layer, a protection layer and an inorganic layer in that order, wherein the organic layer comprises a main component other than a polyparaxylylene, and the protection layer comprises a polyparaxylylene as a main component.

[2] The barrier laminate according to [1], wherein the ratio of (A) the thickness of the protection layer to (B) the thickness of the organic layer (A/B) is less than 1.

[3] The barrier laminate according to [1] or [2], wherein the ratio of (A) the thickness of the protection layer to (B) the thickness of the organic layer (A/B) is less than 0.5.

[4] The barrier laminate according to any one of [1] to [3], wherein the passivatioin layer has a thickness of 10 nm

or more.
[5] The barrier laminate according to any one of [1] to [3], wherein the protection layer has a thickness of 20 to 200 nm.
[6] The barrier laminate according to any one of [1] to [5], wherein the organic layer is formed by curing a polymerizable composition comprising a (meth)acrylate.
[7] The barrier laminate according to any one of [1] to [6], wherein the inorganic layer is formed by a sputtering method.
[8] The barrier laminate according to any one of [1] to [6], wherein the inorganic layer is formed by a CVD method.
[9] The barrier laminate according to any one of [1] to [8], wherein the protection layer and the inorganic layer are successively formed in a vacuum.
[10] The barrier laminate according to any one of [1] to [9], wherein the organic layer has a thickness of 50 to 2000 nm.
[11] The barrier laminate according to any one of [1] to [10], wherein the inorganic layer has a thickness of 5 to 500 nm.
[12] The barrier laminate according to any one of [1] to [11], wherein the protection layer comprises at least 50% by weight of a polyparaxylylene.
[13] The barrier laminate according to any one of [1] to [12], which comprises two or more units consisting of an organic layer, a protection layer and an inorganic layer in that order.
[14] A gas barrier film comprising the barrier laminate according to any one of [1] to [13].
[15] A device comprising the barrier laminate according to any one of [1] to [13].
[16] The device according to [15], having, as a substrate, a gas barrier film comprising the barrier laminate.
[17] The device according to [15] or [16], sealed up with the barrier laminate, or a gas barrier film comprising the barrier laminate.
[18] The device according to any one of [15] to [17], which is an electronic device.
[19] The device according to any one of [15] to [17], which is an organic EL device.
[20] An optical member having, as a substrate, the gas barrier film according to [14].

The present invention made it possible to provide a gas barrier film which has low vapor permeability and of which barrier property does not decrease even if it is bent repeatedly. The present invention also made it possible to provide a device having high heat and humidity durability by using the gas barrier of the present invention.

Description of Specific Embodiments

The contents of the present invention are described in detail hereinunder. In this description, the numerical range expressed by the wording "a number to another number" means the range that falls between the former number indicating the lowermost limit of the range and the latter number indicating the uppermost limit thereof. "Organic EL device" as referred to herein means an organic electroluminescent device. In addition, " (meth) acrylate" means acrylate and methacrylate in the present specification.

<Barrier laminate>

The barrier laminate of the present invention is characterized by comprising an organic layer, an inorganic layer and a protection layer comprising a polyparaxylylene as a main component between the organic layer and the inorganic layer. By employing such means, the present invention makes it possible to reduce damage in forming an inorganic layer and to enhance barrier property of the barrier laminate.

(Inorganic Layer)

The inorganic layer is, in general, a layer of a thin film formed of a metal compound. For forming the inorganic layer, employable is any method capable of producing the intended thin film. For it, for example, suitable are physical vapor deposition methods (PVD) such as vapor evaporation method, sputtering method, ion plating method; various chemical vapor deposition methods (CVD); liquid phase growth methods such as plating or sol-gel method. Not specifically defined, the component to be in the inorganic layer may be any one satisfies the above-mentioned requirements. For example, it includes metal oxides, metal nitrides, metal carbides, metal oxide-nitrides, or metal oxide-carbides. Preferably used are oxides, nitrides, carbide oxide-nitrides, or oxide-carbides comprising at least one metal selected from Si, Al, In, Sn, Zn, Ti, Cu, Ce and Ta. Of those, preferred are oxides, nitrides carbide oxide-nitrides, or oxide-carbides of a metal selected from Si, Al, In, Sn, Zn and Ti; more preferred are metal oxides, nitrides or oxide-nitrides with Si or Al. These may contain any other element as a subsidiary component.

Preferably, the surface smoothness of the inorganic layer formed in the present invention is less than 1 nm in terms of the mean roughness (Ra value) in 1 μm square, more preferably not more than 0.5 nm. Accordingly, it is desirable that the inorganic layer is formed in a clean room. Preferably, the degree of cleanness is not more than class 10000, more preferably not more than class 1000.

Not specifically defined, the thickness of the inorganic layer is generally within a range of from 5 to 500 nm/layer, preferably from 10 to 200 nm/layer. The inorganic layer may be a layer consisting of two or more sub-layers. In the case, as disclosed in UP Laid-Open 2004-46497, the inorganic layers may be gradation layers of which the composition changes continuously in the thickness direction of the layer, with no definite boundary to the adjacent inorganic layer.

(Organic layer)

In the organic layer in the present invention, known polymers may be used. The polymer constituting the organic layer is preferably formed by cuing a polymerizable composition comprising acrylate and/or methacrylate as a main component. Herein, the main component means a component which is the largest in content of all components of the organic layer, preferably a component making up 80% by weight or more of all its components. The organic layer does not comprise a component comprising a polyparaxylylene as a main component.

The polymerizable composition in the present invention preferably comprises at least one species selected from monofunctional (meth)acrylates and multifunctional (meth) acrylates, more preferably (meth) acrylates having two to six functional groups. By using (meth) acrylates having two or more functional groups, a barrier laminate excellent in barrier property after bend is obtained. Particularly, the (meth)acrylate used in the present invention preferably has a molecular weight of 200 to 800 in the case where the organic layer is formed by a vacuum film formation method.

One or more polymerizable compounds may be comprised in the polymerizable composition. Of course, the polymerizable composition may comprise a polymerisable compound other than (meth)acrylates. The content of the polymerizable compound other than (meth) acrylates is typically 1 to 80% by weight, preferably 10% by weight or less.

Examples of the cured article of a (meth) acrylate include a polymer having a structural unit represented by the formula (1):

formula (1) $(Z\text{-}COO)_n\text{-}L$

In formula (1), Z is represented by the following (a) or (b); $R^2$ and $R^3$ in the structures each independently represent a hydrogen atom or a methyl group; * indicates the position at which the structure bonds to the carbonyl group in formula (1); L represents an n-valent linking group; n is an integer of 2 to 6; a number n of Z's may be the same or different, but at least one Z is represented by the following (a):

(a)

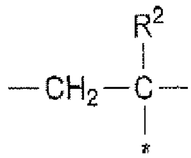

(b)

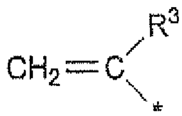

The number of the carbon atoms that constitute L is preferably from 3 to 18, more preferably from 4 to 17, even more preferably from 5 to 16, still more preferably from 6 to 15.

When n is 2, then L represents a divalent linking group. Examples of the divalent linking group include an alkylene group (e.g., 1,3-propylene group, 2,2-dimethyl-1,3-propylene group, 2-butyl-2-ethyl-1,3-propylene group, 1,6-haxylene group, 1,9-nonylene group, 1,12-dodecylene group, 1,16-hexadecylene group), an ether group, an imino group (-NH-), a carbonyl group, and divalent residues of two or more such divalent groups bonding to each other in series (e.g., polyethyleneoxy group, polypropyleneoxy group, propionyloxyethylene group, butyroyloxypropylene group, caproyloxyethylene group, caproyloxybutylene group). Of those, preferred is an alkylene group.

L may have a substituent. Examples of the substituent that L may have include an alkyl group (e.g., methyl group, ethyl group, butyl group), an aryl group (e.g., phenyl group), an amino group (e.g., amino group, methylamino

group, dimethylamino group, diethylamino group), an alkoxy group (e.g., methoxy group, ethoxy group, butoxy group, 2-ethylhexyloxy group), an acyl group (e.g., acetyl group, benzoyl group, formyl group, pivaloyl group), an alkoxycarbonyl group (e.g., methoxycarbonyl group, ethoxycarbonyl group), a hydroxyl group, a halogen atom (e.g., fluorine atom, chlorine atom, bromine atom, iodine atom), a cyano group. The substituent is preferably a group not having an oxygen-containing functional group for the reasons mentioned below, more preferably an alkyl group. Specifically, when n is 2, then L is most preferably an alkylene group not having an oxygen-containing functional group. Having the substituent, the water vapor permeability of the layer may be more lowered.

When n is 3, then L represents a trivalent linking group. Examples of the trivalent linking group include a trivalent residue derived from the above-mentioned divalent linking group by removing one hydrogen atom; and a trivalent residue derived from the above-mentioned divalent linking group by removing one hydrogen atom, followed by substituting it with an alkylene group, an ether group, a carbonyl group or a divalent group of those groups bonding to each other in series. Of those, preferred is a trivalent residue derived from an alkylene group by removing one hydrogen atom, and not containing an oxygen-containing functional group. Having the substituent, the water vapor permeability of the layer may be more lowered. When n is 4 or more, the L represents a tetravalent or more multivalent linking group. The same as above may apply to examples of the tetravalent or more multivalent linking group and also to preferred examples thereof. Especially preferred is a tetravalent residue derived from an alkylene group by removing two hydrogen atoms, and not containing an oxygen-containing functional group. Having the substituent, the water vapor permeability of the layer may be more lowered.

The organic layer in the present invention may contain other polymers. Examples of the other polymers include, for example, polyester, methacrylic acid/maleic acid copolymer, polystyrene, transparent fluororesin, polyimide, fluoropolyimide, polyamide, polyamidimide, polyetherimide, cellulose acylate, polyurethane, polyether ketone, polycarbonate, alicyclic polyolefin, polyarylate, polyether sulfone, polysulfone, fluorene ring-modified polycarbonate, alicyclic-modified polycarbonate, and fluorene ring-modified polyester.

The content of the polymer not having a structural unit is preferably 5 to 50% by weight, more preferably 10% by weight or less.

((Meth)acrylate having a phosphoester group)

The polymerizable composition may comprise a (meth)acrylate having a phosphoester group. The (meth) acrylate having a phosphoester group is preferably a compound represented by the formula (P). The inclusion of the (meth) acrylate compound having a phosphorester group improves the adhesion to the inorganic layer.

formula (P)

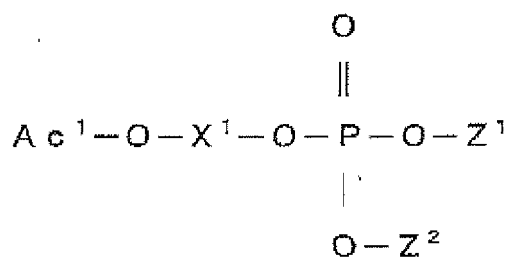

wherein $Z^1$ represents $Ac^2$-O-$X^2$-, a substituent group not having a polymerizable group, or a hydrogen atom, $Z^2$ represents $Ac^3$-O-$X^3$-, a substituent group not having a polymerizable group, or a hydrogen atom, $Ac^1$, $Ac^2$ and $Ac^3$ each represent an acryloyl group or a methacryloyl group, and $X^1$, $X^2$ and $X^3$ each an alkylene group, an alkyleneoxy group, an alkyleneoxycarbonyl group, or an alkylenecarbonyloxy group, or a combination thereof.

The compound represented by the formula (P) is preferably a monofunctional monomer represented by the formula (P-1), a bifunctional monomer represented by the formula (P-2) and a trifunctional monomer represented by the formula (P-3).

formula (P-1)

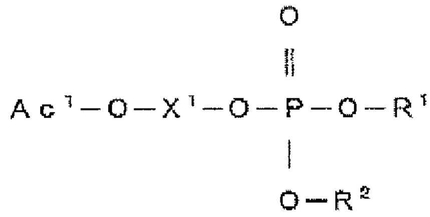

formula (P-2)

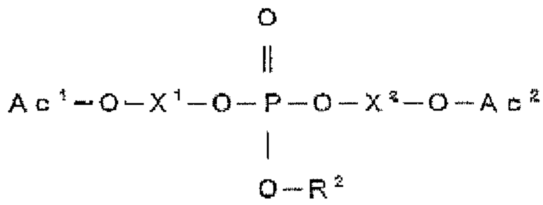

formula (P-3)

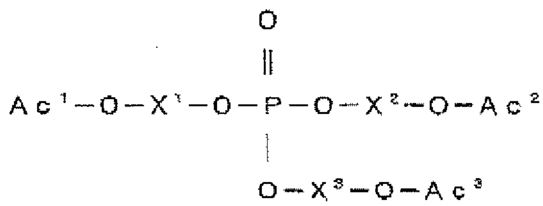

The definitions of $Ac^1$, $Ac^2$, $Ac^3$, $X^1$, $X^2$ and $X^3$ are the same as those in the formula (P). In the formula (P-1) and formula (P-2), $R^1$ represents a substituent not having a polymerizable group, or a hydrogen atom, and $R^2$ represents a substituent group not having a polymerizable group, or a hydrogen atom,

In the formula (P), (P-1) to (P-3), the carbon numbers of $X^1$, $X^2$ and $X^3$ are preferably 1 to 12, more preferably 1 to 6, still more preferably 1 to 4. Examples of the alkylene group, which $X^1$, $X^2$ and $X^3$ may have, and examples of the alkyl nene portion of the alkyleneoxy group, the alkyleneoxycarbonyl group and the alkylenecarbonyloxy group which $X^1$, $X^2$ and $X^3$ may have include a methylene group, an ethylene group, a propylene group, a butylene group, a pentylene group, and a hexylene group. The alkylene group may be a linear or branched alkylene group, preferably a linear alkylene group. $X^1$, $X^2$ and $X^3$ are preferably an alkylene group.

In the formula (P), (P-1) to (P-3), examples of the substituent group not having a polymerizable group include an alkyl group, an alkoxy group, an aryl group and an aryloxy group, and a combination thereof, preferred is an alkyl group and an alkoxy group, and more preferred is an alkoxy group.

The carbon number of the alkyl group is preferably 1 to 12, more preferably 1 to 9, still more preferably 1 to 6. Examples of the alkyl group include a methyl group, an ethyl group, a propyl group, a butyl group, a pentyl group and a hexyl group. The alkyl group may be a linear, branched, or cyclic group, and preferably a linear alkyl group. The alkyl group may be substituted, with an alkoxy group, an aryl group, an aryloxy group, and the like.

The carbon number of the aryl group is preferably 6 to 14, more preferably 6 to 10. Examples of the aryl group include a phenyl group, a 1-naphthyl group, and a 2-naphtyl group. The aryl group may be substituted with an alkyl group, an alkoxy group, an aryloxy group, and the like.

As the alkyl portion of the alkoxy group and the aryl portion of the aryloxy group, the above explanation for the alkyl group and the aryl group may be referred to.

In the present invention, the monomer represented by the formula (P) may be used singly or as combined. When the compounds are used as combined, may be used a combination comprising two or more kinds of a monofunctional compound represented by the formula (P-1), a bifunctional compound represented by the formula (P-2) and a trifunctional compound represented by the formula (P-3).

In the present Invention, as the above polymerizable monomers having a phosphate group, may be used commercially available compounds such as KAYAMER series manufactured by NIPPON KAYAKU CO., LTD, and

Phosmer series manufactured by Uni chemical, and a compound newly synthesized.

Specific examples of the (meth)acrylate having a phosphate group, which is preferably used in the present invention, mentioned below, to which, however, the present invention should not be limited.

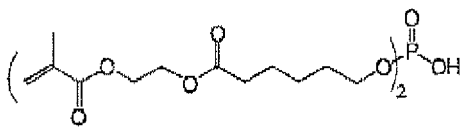

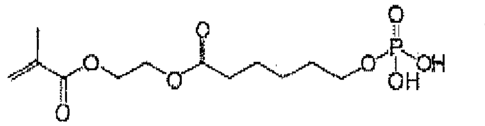

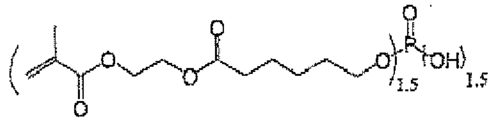

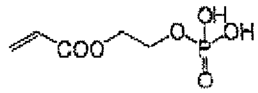

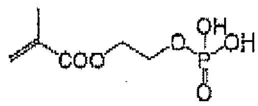

The amount of the (meth) acrylate having a phosphate group in the polymerizable composition is preferably 0.01 to 50 % by weight, more preferably 0.1 to 30 % by weight.

The largest amount of the (math)acrylate having a phosphate group and the polymerizable compound having a bisphenol skeleton and having an aliphatic group of the polymerizable composition is preferably not more than 50 % by weight, more preferably not more than 30 % by weight.

By setting such a range, even when the curing condition is not enough, failure(bleed out) caused by bleeding owing to heat transfer of the uncuring is prevented from occurring. (Polymerization initiator)

The polymerizable composition in the present invention may include a polymerisation initiator. In the case where a photopolymerization initiator is used, its amount is preferably at least 0.1 mol% of the total amount of the polymerizing compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46), etc.

(Method of formation of organic layer)

The method for forming the organic layer is not specifically defined. For example, the layer may be formed according to a solution coating method or a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD, and the like. In the present invention, the polymer may be applied for coating as its solution, or a hybrid coating method along with an inorganic material, as in JP-A 2000-323273 and 2004-25732, may also be used.

In the present invention, the composition comprising the polymerizable monomer is cured by irradiation. The light for irradiation is generally a UV ray from a high-pressure mercury lamp or low-pressure mercury lamp. The radiation energy is preferably at least 0.1 $J/cm^2$, more preferably at least 0.5 $J/cm^2$. (Meth) acrylate series compounds may suffer from interference in polymerization owing to oxygen in air, and therefore, in their polymerization, the oxygen concentration or the oxygen partial pressure is preferably lowered. In the case where the oxygen concentration in polymerization is lowered according to a nitrogen purging method, the oxygen concentration is preferably not more than 2%, more preferably not more than 0.5%. In the case where the oxygen partial pressure in polymerization is lowered by a pressure reduction method, the whole pressure is preferably not more than 1000 Pa, more preferably not more than 100 Pa. Especially preferred is UV polymerization with at least 0.5 $J/cm^2$ energy radiation under a condition of reduced pressure of not

more than 100 Pa.

Preferably, the rate of polymerization of monomer is at least 85%, more preferably at least 88%, even more preferably at least 90%, still more preferably at least 92%. The rate of polymerization as referred to herein means the ratio of the reacted polymerizable group to all the polymerizing group (acryloyl group and methacrylol group) in the monomer mixture. The rate of polymerization may be quantitatively determined according to IR absorptiometry.

When the compositions for polymerizable compounds are the same, the higher the rate of polymerization of monomer is, the higher the hardness of the organic layer is. Generally preferably the hardness of the organic layer is higher. The hardness of the organic layer may be expressed as an icrohardness based on a nano-indentation method. The microhardness of the organic layer is preferably at least 100 N/mm, more preferably at least 150 N/mm, still more preferably at least 200 N/mm.

The thickness of the organic layer is not specifically defined. However, when the layer is too thin, then its thickness could hardly keep uniformity; but when too thick, the layer may be cracked by external force applied thereto and its barrier property may lower. From these viewpoints, the thickness of the organic layer is preferably from 50 nm to 2000 nm, more preferably from 200 nm to 1500 nm.

As so mentioned in the above, the organic layer is preferably smooth. The mean roughness (Ra) in 1 μm square is preferably not more than 1 nm, more preferably not more than 0.5 nm. The surface of the organic layer is required not to have impurities and projections such as particles. Accordingly, it is desirable that the organic layer is formed in a clean room. The degree of cleanness is preferably not more than class 10000, more preferably not more than class 1000.

(Protection layer)

In the present invention, a protection layer comprising a polyparaxylylene as a main component is provided between the organic layer and the inorganic layer. By employing the protection layer, the organic layer as a base layer can be protected from damage in forming the inorganic layer, and the barrier laminate having higher barrier property which is excellent in repetitive bending is obtained.

In forming an inorganic layer, the organic layer to be a base layer is easy to be damaged due to heat, collision energy of inorganic particles, plasma, and the like. Forming an inorganic layer reduces smoothness that the organic layer intrinsically has. The damage for the organic layer may be a cause of reducing barrier property of an inorganic layer formed on the organic layer. This is because the smoothness of a base layer affects the smoothness of the inorganic layer in large degree and because it has a great impact on the barrier property. Stability of the organic layer as a base layer is very important.

When a protection layer consisting of material resistant to damage such as heat, collision energy of inorganic particles, plasma, and the like is used, the damage of the organic layer as a base layer is resolved. However, the protection layer consisting of such a material may be a cause of reducing barrier property of the barrier laminate or barrier property of the barrier laminate after bend. In the present invention, those problems have been solved by providing a protection layer comprising a polyparaxylylene as a main component. The protection layer comprising a polyparaxylylene as a main component means that the content of a polyparaxylylene is the largest. The protection layer preferably comprises 50% by weight or more of a polyparaxylylene, more preferably 80% by weight or more from the viewpoints that such a layer works effectively as a protection layer.

In forming the inorganic layer, examples of the damage for the organic layer as a base layer include physical damage by a sputtering method and plasma damage by a plasma CVD method.

In the case of the physical damage for the organic layer by a sputtering method, the relation between hardness of the organic layer and hardness of the protection layer preferably satisfies as follows: (the hardness for the protection layer) > (the hardness for the organic layer), preferably (the hardness for the protection layer) /(the hardness for the organic layer) > 1.0 from the viewpoints that the Stress relaxation effect of the organic layer is not undermined. The hardness of the organic layer may be expressed as hardness based on a nano-indentation method. The hardness of the protection layer is preferably at least 100 $N/mm^2$, more preferably at least 150 $N/mm^2$, further more preferably at least 200 $N/mm^2$.

The plasma damage may be suppressed by adjusting the value defined as Ohnishi parameter or Ring parameter which is known as an index of plasma etching of an organic layer. The plasma etching resistance has been discussed as etching workability and is disclosed in J. Photopolymer Sci. and Technol. Vol.5 No.3 (1992) p439 and J. Electrochem. Soc. :Solid-State Sci. and Technol. vol.130, No.1 January (1983) p143, SPIE Vol.2724 p365 (1996). Ohnishi parameter is defined as a ratio of hetero atoms (oxygen atoms) in a molecule. The higher the number of the ratio is, the more easily the etching is carried out. In order to lower plasma damage, it is effective to reduce Ohnishi parameter, that is, the number of oxygen atoms is reduced in the molecule. Ring parameter is defined as a ratio of double bonds in a molecule. The higher the ratio of aromatic ring is, the higher the resistance to plasma is.

Examples of the polyparaxylylene used in the present invention include polydichloroparaxylylene and polychloroparaxylylene.

Since a polyparaxylylene is a crystalline polymer having, as a base skeleton, a skeleton in which aromatic rings not having a hetero atom connect to each other, hardness of the film is extremely high and the plasma resistance is also extremely high. A polyparaxylylene is obtained by carrying out heating evaporation of diparaxylylene as a material in a high vacuum, generating radical by carrying out heating decomposition of this steam, advancing a radical polymerization reaction simultaneously with absorption to a base material, and making it accumulate on a substrate. Since the protection layer used in the present invention is extremely excellent in mechanical strength, thermal resistance and chemical resistance, the present invention is extremely effective to prevent the organic layer from being damaged in forming the inorganic layer.

The thickness of the protection layer in the present invention is preferably 10 nm or more, more preferably 20 to 200 nm, further more preferably 50 to 100 nm. By setting the thickness of the protection layer to the above range, the organic layer is prevented from being damaged in forming the organic layer.

Further, the ratio of the thickness of the protection layer to the thickness of the organic layer in the present invention is preferably as follows:

(the thickness of the protection layer)/(the thickness of the organic layer) < 1,

more preferably

(the thickness of the protection layer)/(the thickness of the organic layer) < 0.5,

further preferably

(the thickness of the protection layer)/(the thickness of the organic layer) < 0.2.

By setting such a ratio of the thicknesses, stress relaxation effect of the organic layer can be sufficiently exerted.

(Lamination)

Lamination of the organic layer, the protection layer and the inorganic layer can be carried out by a known method. When the Inorganic layer is formed by a vacuum film formation method such as a sputtering method, a vapor evaporation method, an ion plating method, a plasma polymerization method, or a CVD method, the organic layer and the protection layer are preferably formed by a vacuum film formation. During the formation of the barrier laminate, the pressure is preferably in a vacuum of at most 100 Pa all the time. The pressure is preferably not more than 10 Pa, more preferably not more than 1 Pa. Particularly, the protection layer in the present invention is preferably carried out by a vacuum film formation method such as a plasma polymerization method, or a CVD method. In the case, the protection layer is preferably successively formed in vacuum as well as the inorganic layer and the organic layer.

(Constitution of Barrier Laminate)

The barrier laminate of the present invention comprises an organic layer, a protection layer and an inorganic layer in that order, preferably two or more units consisting of the organic layer, the protection layer and the inorganic layer.

The barrier laminate may comprise a functional layer. The functional layer may be provided between the units or on the outermost surface of the unit. The functional layer is described in detail in JP-A 2006-289627, paragraphs 0036 to 0038. Examples of other functional layers than those are a matting agent layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an easy adhesive layer, etc.

(Use of Barrier Laminate)

In general, the barrier laminate of the present invention is formed on a support. Selecting the support, the barrier laminate may have various applications. The support includes a substrate film, as well as various devices, optical members, etc. Concretely, the barrier laminate of the present invention may be used as a barrier layer of a gas barrier film. The barrier laminate and the gas barrier film of the present invention may be used for sealing up devices that require barrier performance. The barrier laminate and the gas barrier film of the present invention may apply optical members. These are described in detail hereinunder.

<Gas barrier film>

The gas barrier film comprises a substrate film and a barrier laminate formed on the substrate film. In the gas barrier film, the barrier laminate of the present invention may be provided only one surface of the substrate film, or may be provided on both surfaces thereof. The barrier laminate of the present invention may be laminated in an order of an inorganic layer and an organic layer from the side of the substrate film; or may be laminated in an order of an organic layer and an inorganic layer from it. The uppermost layer of the laminate of the present invention may be an inorganic layer or an organic layer.
The gas barrier film of the present invention is a film substrate having a barrier layer that functions to block oxygen, water, nitrogen oxide, sulfur oxide, ozone and others in air.
Not specifically defined, the number of the layers that constitute the gas barrier film may be typically from 2 layers to 30 layers, more preferably from 3 layers to 20 layers.
The gas barrier film may have any other constitutive components (e.g., functional layers such as adhesive layer) in addition to the barrier laminate and the substrate film. The functional layer may be disposed on the barrier laminate, or between the barrier laminate and the substrate film, or on the side (back) of the substrate film not coated with the barrier laminate.

(Plastic Film)

In the gas barrier film of the present invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclicpolyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.
In case where the gas barrier film of the present invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of not less than 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (Mitsubishi gas chemical company's Neopulim : 260°C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.
In the case where the gas barrier film of the present invention is used in combination with a polarizing plate, it is preferable that the gas barrier layer surface of the gas barrier film is faced at the inside of a cell and is disposed in the innermost (adjacent to the device). At that time, since the gas barrier film is disposed in the inside of the cell relative to the polarizing plate, a retardation value of the gas barrier film is important. As to a use form of the gas barrier film in such an embodiment, it is preferable that a barrier film using a base material film having a retardation value of not more than 10 nm and a circular polarizing plate ((quarter-wave plate) + (half-wave plate) + (linear polarizing plate)) are laminated and used, or that a linear polarizing plate is combined with a gas barrier film using a base material film having a retardation value of from 100 nm to 180 nm, which can be used as a quarter-wave plate, and used.
Examples of the base material film having a retardation of not more than 10 nm include cellulose triacetate

(FUJITAC, manufactured by Fujifilm Corporation), polycarbonates (PURE-ACE, manufactured by Teijin Chemicals Ltd.; and ELMECH, manufactured by Kaneka Corporation), cycloolefin polymers (ARTON, manufactured by JSR Corporation; and ZEONOR, manufactured by Zeon Corporation), cycloolefin copolymers (APEL (pellet), manufactured by Mitsui Chemicals, Inc.; and TOPAS (pellet), manufactured by Polyplastics Co., Ltd.), polyarylates (U100 (pellet), manufactured by Unitika Ltd.) and transparent polyimides (NEOPULIM, manufactured by Mitsubishi Gas Chemical Company).

Also, films obtained by properly stretching the foregoing film to adjust it so as to have a desired retardation value can be used as the quarter-wave plate.

In view of the matter that the gas barrier film of the present invention is utilized as a device such as organic EL devices, the plastic film must be transparent, namely its light transmittance is usually not less than 80%, preferably not less than 85%, and more preferably not less than 90%. The light transmittance can be measured by a method described in JIS-K7105, namely by measuring a total light transmittance and an amount of scattered light using an integrating sphere type light transmittance analyzer and subtracting the diffuse transmittance from the total light transmittance.

Even in the case where the gas barrier film of the present invention is used for display use, for example, when it is not disposed on the side of an observer, the transparency is not always required. Accordingly, in such case, an opaque material can also be used as the plastic film. Examples of the opaque material include a known liquid crystal polymer such as polyimides and polyacrylonitrile.

The thickness of the plastic film to be used for the gas barrier film of the present invention is properly chosen depending upon the use and therefore, is not particularly limited. It is typically from 1 to 800 μm, and preferably from 10 to 200 μm. These plastic films may have a functional layer such as a transparent conductive layer and a primer layer. The functional layer is described in detail in paragraphs 0036 to 0038 of JP-A-2006-289627.

<Device>

The barrier laminate and the gas barrier film of the present invention are favorably used for devices that are deteriorated by the chemical components in air (e.g., oxygen, water, nitrogen oxide, sulfur oxide, ozone). Examples of the devices are, for example, organic EL devices, liquid-crystal display devices, thin-film transistors, touch panels, electronic papers, solar cells, other electronic devices. More preferred are organic EL devices.

The barrier laminate of the present invention may be used for film-sealing of devices. Specifically, this is a method of providing a barrier laminate of the present invention on the surface of a device serving as a support by itself. Before providing the barrier laminate, the device may be covered with a protective layer.

The gas barrier film of the present invention may be used as a substrate of a device or as a film for sealing up according to a solid sealing method. The solid sealing method comprises forming a protective layer on a devices, then forming an adhesive layer and a gas barrier film as laminated thereon, and curing it. Not specifically defined, the adhesive may be a thermosetting epoxy resin, a photocurable acrylate resin, etc.

(Organic EL Device)

Examples of an organic EL device with a gas barrier film are described in detail in JP-A 2007-30387.

(Liquid-Crystal Display Device)

A reflection-type liquid-crystal display device has a constitution of a lower substrate, a reflection electrode, a lower alignment film, a liquid-crystal layer; an upper alignment film, a transparent electrode, an upper substrate, a λ/4 plate and a polarizing film, formed in that order from the bottom. In this, the gas barrier film of the present invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the substrate of the present invention may be sued as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (super-twisted nematic) type, a HAN (hybrid aligned nematic) type, a VA (vertically alignment) type, an ECB (electrically controlled birefringence) type, an OCB (optically compensatory bent) type, an IPS (in-plane switching) type, or a CPA (continuous pinwheel alignment) type.

(Solar Cell)

The barrier film substrate of the invention can be used also as a sealing film for solar cell devices. Preferably, the barrier film substrate of the invention is used for sealing a Solar cell device in such a manner that its adhesive layer is on the side near to the solar cell device. The solar cell devices for which the barrier film substrate of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selanium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copperlindium/gallium/selenium (CIGS-based), copper/indium/gallium/selenium/sulfur (CIGSS-based) or the like I-III-VI Group compound semiconductor-based solar cell devices.

<Electronic paper>

The gas barrier film of the Invention can be used in an electronic paper. The electronic paper is a reflection-type electronic display capable of attaining a high precision and a high contrast.

The electronic paper has a display media and a TFT driving the display media on a substrate. Any known display media can be used in the electronic paper. For example, any display media of electophoretic-type, electopowder flight-type, charged tonner-type, electrochromic type can be preferably used. Among them, electophoretic display media is more preferable and microcapsule-type electophoretic display media is particularly preferable. The electophoretic display media has a plural number of capsules and each capsule has at least one particle capable of moving in a suspension flow. The at least one particle is preferably an electrophoretic particle or a spinning ball. The electrophretic display media has a first plane and a second plane that are placed in parallel, and an image is displayed through one of the two planes.

A TFT formed on a substrate comprises a gate electrode, gate insulating layer, an active layer, a source electrode and a drain electrode. A TFT also comprises a resistance layer between the active layer and the source electrode and/or between the active layer and the drain electrode to attain electric connection.

When a color display with a high precision is produced, TFT's are preferably formed on a color filter to precisely align them. Normal TFT with a low electric efficiency can not be down-sized much while obtaining the necessary driving current, and when a high precision display is pursued, the rate of the area for the TFT in a pixel must be high. When the rate of the area for the TFT is high, the rate of the opening area and contrast are low.
Even when a transparent amorphous IGZO-type TFT is used, light transmittance is not 100% and reduction of contrast is unavoidable. Use of the TFT disclosed in JP-A 2009-21554 and the like can reduce the rate of the TFT in a pixel and improve the rate of the opening area and contrast. High precision can also be attained by forming this type of TFT on a color filter directly.

(Others)

Other applications of the invention are thin-film transistors as in JP-T H10-512104, and touch panels as in JP-A 5-127822, 2002-48913.

<Optical Member>

Examples of the optical member that comprises the barrier laminate of the present invention are a circular polarizer and the like.

(Circular Polarizer)

Laminating a gas barrier film of the invention with a $\lambda/4$ plate and a polarizer gives a circular polarizer. In this case, the components are so laminated that the slow axis of the $\lambda/4$ plate could cross the absorption axis of the polarizer at an angle of 45°. The polarizer is preferably stretched in the direction of 45° from the machine direction (MD) thereof; and for example, those described in JP-A 2002-865554 are favorably used.

EXAMPLES

The characteristics of the present invention are described more concretely with reference to the following Examples. Accordingly, the present invention should not be limitatively interpreted by the Examples mentioned below.

1. Formation of a gas barrier film

(Example 1)

On a flexible substrate, an organic layer, a protection layer and an inorganic layer were reread in that order according to the following process.

As the flexible substrate, used was a polyethylene naphthalate film (PEN, having a thickness of 100 μm, manufactured by DuPont, Teonex Q65A) which was cut into 20 cm square pieces. A barrier laminate was formed on the smooth surface side thereof.

The organic layer, the organic layer and the inorganic layer were formed with an organic/inorganic laminate film formation device (Vitex Systems' Guardian 200). The protection layer was formed in vacuum in a succession of the organic layer and the inorganic layer.

(1-1) Formation of Organic Layer 1

As a material of the organic layer 1, used was a polymerisable composition comprising propoxylated neopentyl glycol diacrylate (70g), etoxylated trimethylolpropanetriacrylate (30g), and an ultraviolet polymerisation initiator (ESACURE-TZT, 5g). At the inside pressure of 3Pa, a film of the polymerizable composition was formed by a flash vapor deposition method, and was irradiated with UV rays at $2J/cm^2$ and cured. The thickness of the organic layer 1 was 1000 nm.

(1-2) Formation of Protection layer 1

Using dichloroparaxylylene (manufactured by Daisankasei Co Ltd, diX C) as a material, a protection layer consisting of poly(dichloroparaxylylene) was formed by a CDV method. The thickness of the protection layer was 100 nm.

(1-3) Formation of Inorganic Layer 1

An inorganic layer 1 consisting of aluminium oxide was formed with Guardian 200 by a sputtering method. The thickness of the inorganic layer 1 is 50 nm.

The obtained gas barrier film was named A.

(Comparative Example 1)

Gas barrier film B was produced in the same manner as Example 1, except that, on a PEN film, the protection layer having a thickness of 1100 nm and the inorganic layer 1 having a thickness of 50 nm were formed in that order without forming the organic layer 1.

(Comparative Example 2)

Gas barrier film C was produced in the same manner as Example 1, except that, on a PEN film, the organic layer 1 having a thickness of 1100 nm and the inorganic layer 1 having a thickness of 50 nm were formed in that order without forming the protection layer.

(Comparative Example 3)

Gas barrier film D was produced in the same manner as Example 1, except for the following processes:

on a PEN film, the organic layer 1 having a thickness of 500 nm was formed; on the surface, an organic layer 2 was formed without forming the protection layer; as a material of the organic layer 2, used was a polymerizable composition comprising 2-hydroxy-3-phanoxypropylacrylate (90 g), propoxylated neopentyl glycol diacrylate (10 g) and an ultraviolet polymerization initiator (ESACURE-TZT, 5g); the thickness of the organic layer 2 was 500 nm; on the surface of the organic layer 2, the inorganic layer 1 having a thickness of 50 nm was formed.

(Comparative Example 4)

Gas barrier film E was produced in the same manner as Example 1, except for the following processes:

on a PEN film, the organic layer having a thickness of 1000 nm was formed; on the surface thereof, an inorganic layer 2 consisting of $SiO_2$ and having a thickness of 100 nm was formed by a plasma CVD method without forming the protection layer; on the surface of the inorganic layer 2, the inorganic layer 1 consisting of aluminium oxide having a thickness of 50 nm was formed.

(Evaluation of barrier property)

(1) Measurement of water vapor permeability according to Ca method

A test sample was prepared by carrying out vapor-deposition of metal Ca on the surface of the barrier laminate of the gas barrier film, and sealing the gas barrier film and a glass substrate with a commercially available sealant for an organic EL device so that the deposited site faces inside. The test sample was left at 40°C and a relative humidity of 90%. The water vapor permeability of the gas barrier film was measured from an optical concentration change of metal Ca on the gas barrier film. Due to hydroxylation or oxidation of Ca, its metallic luster decreases and its color deteriorates.

(2) Repetitive bending test

A repetitive bending test was conducted at 25 °C for the above obtained gas barrier films. The bending test was conducted at IPC bending test according to IPC standard TM-650. In the test, the film was put between a fixed plate and a moveable plate in a bent state with a barrier surface being convexed and the moveable plate is moved repetitively. A film was set to 10 mmR (curvature radius) and 60 mm stroke and test was conducted for the repetitive cycles of 50 times and 500 times.

Then, also for the gas barrier film conducted for the repetitive bending test, the barrier property was evaluated according the above Ca test.

The results are shown in Table 2. In the tables, VMP means vapor water permeability.

[Table 1]

| Sample | Layer Structure | Remarks |
|---|---|---|
| A | Inorganic Layer 1 (60nm) /Passivation Layer (100m) /Organic Layer 1 (1000nm) /PEN | Example 1 |
| B | Inorganic Layer 1 (50nm) /Passivation Layer (1100nm) /PEN | Comparative Example 1 |
| C | Inorganic Layer 1 (50nm) /Organic Layer 1 (1100nm) /PEN | Comparative Example 2 |
| D | Inorganic Layer 1 (50nm) /Organic Layer 2 (500nm) /Organic Layer 1 (500nm) /PEN | Comparative Example 3 |
| E | Inorganic Layer 1 (50nm) /Inorganic Layer 2 (100nm) /Organic Layer 1 (1000nm) /PEN | Comparative Example 4 |

[Table 2]

| Sample | VWP before bend ($g/m^2/day$) | VWP after 60 times of bend ($g/m^2/day$) | VWP after 500 times of bend ($g/m^2/day$) | Remarks |
|---|---|---|---|---|
| A | 0.0006 | 0.0006 | 0.0008 | Example 1 |
| B | 0.0008 | 0.008 | 0.15 | Comparative Example 1 |
| C | 0.005 | 0.005 | 0.005 | Comparative Example 2 |
| D | 0.003 | 0.003 | 0.004 | Comparative Example 3 |
| E | 0.001 | 0.003 | 0.005 | Comparative Example 4 |

As is clear from the results in Tables 1 and 2, the gas barrier film A (Example 1) having the protection layer between the organic layer and the inorganic layer has higher water vapor permeability than the gas barrier film C not having the protection layer (Comparative Example 2). It was found that the gas barrier film B (Comparative Example 1) consisting of the protection layer and the inorganic layer without any organic layer significantly decrease in the water vapor permeability after it bent.
It was found that the gas barrier film of the present invention has high water vapor permeability, and maintained the high level of the water vapor permeability even after the gas barrier film was repetitively bent.

2. Evaluation in Organic EL Device

(2-1) Formation of Organic EEL Device 1 (BOEL-1)

(2-1-1) Formation of Organic EL Device

An ITO film-having conductive glass substrate (surface resistivity, 10 Ω/square) was washed with 2-propanol, and then processed for UV ozone treatment for 10 minutes. On the substrate (anode), the following compound layers were formed in order by vapor deposition according to a vacuum vapor deposition method.

(First Hole Transporting Layer)

Copper phthalocyanine: film thickness 10 nm.

(Second Hole Transporting Layer)

N,N'-d-diphenyl-N,N'-dinaphthylbenzidine: film thickness 40 nm.

(Light-Emitting Layer also serving as electron transporting layer)

Tris(8-hydroxyquinolinato)aluminium: film thickness 60 nm.

(Electron Injection Layer)

Lithium fluoride: film thickness 1 nm.
A metal aluminium was formed on it through vapor deposition to form a cathode having a thickness of 100 nm, and a silicon nitride film having a thickness of 5 μm was formed thereon according to a parallel plate CVD method, thereby constructing an organic EL device.

(2-1-2) Placing the Gas Barrier Film on the Organic EL Device

Using a thermosetting adhesive (Epotec 310, by Daizo-Nichimori), the organic EL device formed above 2-1-1 and the gas barrier film A were stuck together in such a manner that the side of the barrier layer could be on the side of the organic EL device, and heated at 65°C for 3 hours to cure the adhesive. The thus-sealed organic EL device (BOEL-1) was prepared.

(2-2) Formation of Organic EL Device 2 (BOEL-2)

(2-2-1) Formation of Organic EL Device

Using DC power source, an anode layer of indium tin oxide (ITO, indium/tin=95/5, molar ratio) was formed on the gas barrier film A by a sputtering method. On the anode layer, an organic EL device was formed in the same manner as the produce described in the 2-1-1.

(2-2-2) Placing the Gas Barrier Film on the Organic EL Device

Using a thermosetting adhesive (Epotec 310, by Daizo-Nichimori), the gas barrier film A and the organic EL device formed in the above 2-1-1 were stuck together in such a manner that the side of the barrier layer could be on the side of the organic EL device, and heated at 65°C for 3 hours to cure the adhesive. The thus-sealed organic EL device (BOEL-2) was prepared.

3. Evaluation of Light Emission Surface of the Organic EL Device

Just after produced, the organic EL devices (BOEL-1, BOEL-2) were tested for light emission under application of 7 V thereto, using a source measure unit (SMU2400 Model by Keithley). Using a microscopy, the light-emitting surface was observed. Then, the organic EL devices (BOEL-1, BOEL-2) were stored in a dark room at 40°C and 90% RH for 60 days, and then tested for light emission. For the ratio of the light emission area after the storage to before the storage, BOEL-1 was 96% and BOEL-2 was 80%.

It was confirmed that both of the organic EL (BOEL-1) device sealed with the gas barrier film of the present invention and the organic EL device (BOEL-2) which is sealed with the gas barrier film of the present invention and in which the gas barrier film is used as a substrate are excellent in heat and humidity resistance.

## Claims

**1.** A barrier laminate comprising an organic layer, a passivation layer and an inorganic layer in that order, wherein the organic layer comprises a main component other than a polyparaxylylene, and the passivation layer comprises a polyparaxylylene as a main component.

**2.** The barrier laminate according to Claim 1, wherein the ratio of (A) the thickness of the passivation layer to (B) the thickness of the organic layer (A/B) is less than 1.

**3.** The barrier laminate according to Claim or 2, wherein the passivatioin layer has a thickness of 10 nm or more.

**4.** The barrier laminate according to any one of Claims 1 to 3, wherein the organic layer is formed by curing a polymerizable composition comprising a (meth)acrylate.

**5.** The barrier laminate according to any one of Claims 1 to 4, wherein the inorganic layer is formed by a sputtering method.

**6.** The barrier laminate according to any one of Claims 1 to 4, wherein the inorganic layer is formed by a CVD method.

**7.** The barrier laminate according to any one of Claims 1 to 6, wherein the passivation layer and the inorganic layer are successively formed in a vacuum.

**8.** The barrier laminate according to any one of Claims 1 to 7, which comprises two or more units consisting of an organic layer, a passivation layer and an inorganic layer in that order.

**9.** A gas barrier film comprising the barrier laminate according to any one of Claims 1 to 8.

**10.** A device comprising the barrier laminate according to any one of Claims 1 to 8.

**11.** The device according to Claim 10, having, as a substrate, a gas barrier film comprising the barrier laminate.

**12.** The device according to Claim 10 or 11, sealed up with the barrier laminate or a gas barrier film comprising the barrier laminate.

**13.** The device according to any one of Claims 10 to 12, which is an electronic device.

**14.** The device according to any one of Claims 10 to 12, which is an organic EL device.

**15.** An optical member having, as a substrata, the gas barrier film according to Claim 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 53012953 B
- JP 58217344 A
- JP 2003335880 A
- JP 2003335820 A
- US P2681294 A
- JP 2000323273 A
- JP 2004025732 A
- JP 2006289627 A
- JP 2001150584 A
- JP 2000227603 A
- JP 2002080616 A
- JP 2007030387 A
- JP 2009021554 A
- JP H10512104 T
- JP 5127822 A
- JP 2002048913 A
- JP 2002865554 A


### Non-patent literature cited in the description


- *J. Photopolymer Sci. and Technol.,* 1992, vol. 5 (3), 439
- *J. Electrochem. Soc. :Solid-State Sci. and Technol.,* January 1983, vol. 130 (1), 143
- *SPIE,* 1996, vol. 2724, 365